(19) **Europäisches Patentamt / European Patent Office / Office européen des brevets**

(11) **EP 4 718 645 A1**

(12) **EUROPEAN PATENT APPLICATION**

(43) Date of publication:
01.04.2026 Bulletin 2026/14

(21) Application number: 25202839.4

(22) Date of filing: 17.09.2025

(51) International Patent Classification (IPC):
$H01S\ 5/042^{(2006.01)}$ $G01S\ 7/484^{(2006.01)}$
$H01S\ 5/06^{(2006.01)}$ $H01S\ 5/183^{(2006.01)}$
$H01S\ 5/065^{(2006.01)}$

(52) Cooperative Patent Classification (CPC):
H01S 5/0601; G01S 7/484; H01S 5/0428;
H01S 5/0615; H01S 5/18313; H01S 5/18358;
H01S 5/0658; H01S 5/18347

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 27.09.2024 JP 2024168081
28.08.2025 JP 2025142018

(71) Applicant: Canon Kabushiki Kaisha
Tokyo, 146-8501 (JP)

(72) Inventors:
• UCHIDA, Takeshi
Tokyo, 146-8501 (JP)
• SUGA, Takako
Tokyo, 146-8501 (JP)
• UCHIDA, Tatsuro
Tokyo, 146-8501 (JP)

(74) Representative: Canon Europe Limited
European Intellectual Property Group
4 Roundwood Avenue
Stockley Park
Uxbridge UB11 1AF (GB)

(54) **LIGHT EMITTING DEVICE, RANGING DEVICE, AND MOVABLE BODY**

(57) There is included a spacer portion (14) including a saturable absorption layer (16) provided between a first electrode (140), which is a back electrode, and a resonator portion (18, 29). The spacer portion (14) has a first spacer layer (134) provided on the first side with respect to the saturable absorption layer (16) and a second spacer layer (144) provided on the second side with respect to the saturable absorption layer (16). Each of the first spacer layer (134) and the second spacer layer (144) is of a first conductivity type.

## FIG. 1A

**Description**

TECHNICAL FIELD

The present disclosure relates to a light emitting device, a ranging device, and a movable body.

BACKGROUND

Using a VCSEL (vertical cavity surface emitting laser) as a light source for LiDAR using a ToF (time of flight) method is known. VCSELs have an advantage of low wavelength dependence on temperature.
Japanese Patent Laid-Open Publication No. 2022-176886 describes a VCSEL capable of increasing the peak value of an optical pulse to be emitted.

SUMMARY

The present disclosure in its first aspect provides a light emitting device as specified in claim 1. Optional features are specified in claims 2 to 22.
The present disclosure in its second aspect provides a ranging device as specified in claim 23. Optional features of the second aspect are specified in or derivable from claims 2 to 22.
The present disclosure in its third aspect provides a movable body as specified in claim 24. Optional features of the third aspect are specified in or derivable from claims 2 to 22.
Features of the present disclosure will become apparent from the following description of embodiments with reference to the attached drawings. The following description of embodiments is described by way of example.

BRIEF DESCRIPTION OF THE DRAWINGS

Fig.1A is a schematic sectional view illustrating a light emitting element in a first embodiment.
Fig. 1B is a schematic sectional view illustrating the light emitting element in the first embodiment.
Fig. 2 is a schematic sectional view illustrating details of a spacer layer of the light emitting element in the first embodiment.
Fig. 3A is a schematic sectional view illustrating details of a spacer layer of a light emitting element in a second embodiment.
Fig. 3B is a schematic sectional view illustrating details of the spacer layer of the light emitting element in the second embodiment.
Fig. 4 is a calculation example of an electron density of the spacer layer of the light emitting element in the second embodiment.
Fig. 5 is a graph illustrating a relationship between an electron density inside a quantum well layer of the light emitting element in the second embodiment and an optical response waveform.
Fig. 6A is a graph illustrating a relationship between an electron density inside the quantum well layer of the light emitting element in the second embodiment and peak intensity.
Fig. 6B is a graph illustrating a relationship between an electron density inside the quantum well layer of the light emitting element in the second embodiment and peak intensity.
Fig. 7 is a schematic sectional view illustrating details of a spacer layer of a light emitting element in a third embodiment.
Fig. 8 is a block diagram illustrating a general configuration of a ranging device according to a fifth embodiment.
Fig. 9A is a schematic sectional view illustrating a light emitting element in a comparative example.
Fig. 9B is a schematic sectional view illustrating the light emitting element in the comparative example.
Fig. 10 is a graph illustrating a relationship between light extraction efficiency and band gap difference.
Fig. 11A is a calculation example of an electron density of a spacer layer of a light emitting element.
Fig. 11B is a graph illustrating a relationship between an electron density and a doping concentration.
Fig. 12A is a calculation example of an electron density of a spacer layer of a light emitting element.
Fig. 12B is a graph illustrating a relationship between an average electron density and the thickness of a barrier layer.
Fig. 12C is a graph illustrating a relationship between an electric current value and the thickness of a barrier layer.
Fig. 13A is a calculation example of an electron density of a spacer layer of a light emitting element.
Fig. 13B is a calculation example of an electron density of a spacer layer of a light emitting element.
Fig. 14 is a schematic sectional view illustrating a light emitting element in a fourth embodiment.

Fig. 15 is a calculation example of an electron density of a spacer layer of a light emitting element.

DESCRIPTION OF THE EMBODIMENTS

The following embodiments are for embodying a technical concept of the present disclosure and are not intended to limit the present disclosure solely to the disclosed embodiments. Sizes and positional relationships of members illustrated in each of the drawings may be exaggerated for clarifying description. In the following description, description of identical components may be omitted by giving identical numbers thereto.

Hereinafter, embodiments of the present disclosure will be described in detail on the basis of the drawings. Note that terms denoting specific directions or locations (for example, "up", "down", "right", "left", and other terms including these terms) are used, as necessary, in the following description. The use of those terms is for ease of understanding of embodiments for which the drawings are referred, and the meaning of those terms are not intended to limit technical scope. For example, terms such as "lower reflecting mirror", "upper reflecting mirror", "lower electrode", and "upper electrode" are used for a VCSEL, and these terms are merely expressions for specifying relative positions. Therefore, when a light emitting element is reversely mounted in the up-down direction, a reflecting mirror located above can be called "lower reflecting mirror" and a reflecting mirror located below can be called "upper reflecting mirror".

In the following description, a semiconductor of a first conductivity type and a semiconductor of a second conductivity type, which is a conductivity type opposite to the first conductivity type, are referred to as an N-type semiconductor and a P-type semiconductor, respectively. However, the semiconductor of the first conductivity type and the semiconductor of the second conductivity type may be the P-type semiconductor and the N-type semiconductor, respectively. In addition, a non-doped or undoped semiconductor can be referred to as an i-type semiconductor, and the i-type can be referred to as a third conductivity type.

The term "impurity concentration" that is simply used in the present specification denotes a net impurity concentration excluding a portion compensated by an impurity of a reverse-conductivity type. That is, the "impurity concentration" denotes a NET doping concentration. A region in which a P-type additive impurity concentration is higher than an N-type additive impurity concentration is a P-type semiconductor region. Conversely, a region in which the N-type additive impurity concentration is higher than the P-type additive impurity concentration is an N-type semiconductor region. Note that generating carriers by inputting an impurity into a semiconductor may be expressed below as doping.

Comparative Example

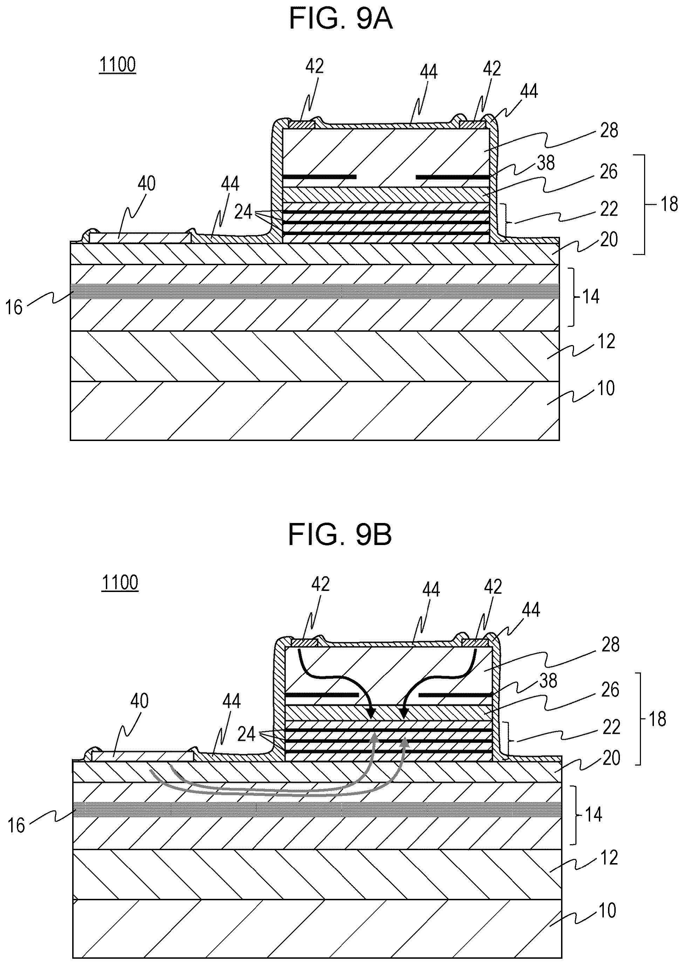

Before describing a first embodiment of the present disclosure, a comparative example will be described with Figs. 9A and 9B. Fig. 9A is a schematic sectional view illustrating a structure of a comparative example.

A light emitting element 1100, which is a comparative example, is a vertical-resonator-type surface emitting laser (VCSEL) that includes a distributed bragg reflector (DBR). As illustrated in FIG. 9A, the light emitting element 1100 includes a semiconductor substrate 10, a lower DBR layer 12 (first reflecting mirror), a spacer portion 14, and an upper DBR layer 28 (second reflecting mirror), which are disposed in this order. The light emitting element 1100 includes electrodes 40 and 42 and a protection film 44. The lower DBR layer 12 is provided on the semiconductor substrate 10. The spacer portion 14 is provided on the lower DBR layer 12. The upper DBR layer 28 is provided on a resonator portion 18. Layers (the spacer portion 14 and the resonator portion 18) located between the lower DBR layer 12 and the upper DBR layer 28 form a resonator spacer portion.

A saturable absorption layer 16 is provided in the spacer portion 14. The resonator portion 18 is constituted by an n-type layer 20 provided on the spacer portion 14, a non-doped spacer portion 22 provided on the n-type layer 20, and a p-type layer 26 provided on the non-doped spacer portion 22. Active layers 24, which are three layers of quantum well layers, are provided in the non-doped spacer portion 22. An oxidized constriction layer 38 is provided in the upper DBR layer 28. The total number of the quantum well layers is not limited to three and may be four or other than four.

The non-doped spacer portion 22, the p-type layer 26, and the upper DBR layer 28 are processed into a mesa shape. The electrode 40 electrically connected to the n-type layer 20 is provided on the n-type layer 20 that is exposed as a result of the non-doped spacer portion 22, the p-type layer 26, and the upper DBR layer 28 being processed into the mesa shape. The electrode 42 electrically connected to the upper DBR layer 28 is provided on the upper DBR layer 28. The protection film 44 is provided at an upper surface of the n-type layer 20 and side surfaces and an upper surface of the mesa, excluding at least a portion of surfaces of the electrodes 40 and 42.

The semiconductor substrate 10 can be constituted by, for example, a GaAs substrate. The lower DBR layer 12 can be constituted by, for example, thirty five pairs of an $Al_{0.1}GaAs$ layer and an $Al_{0.9}GaAs$ layer, each having an optical film thickness of 1/4 $\lambda c$, that are laminated as a laminated body. Here, $\lambda c$ is a center wavelength of a high reflection band of the lower DBR layer 12. For example, $\lambda c$ is 940 nm.

The saturable absorption layer 16 in the spacer portion 14 can be constituted by, for example, a multi-quantum well including three layers of quantum wells in each of which an InGaAs well layer having a thickness of 8 nm is sandwiched between AlGaAs barrier layers each having a thickness of 10 nm. The other portion of the spacer portion 14 can be constituted by a non-doped GaAs layer.

The resonator portion 18 is constituted by a p-i-n junction including the n-type layer 20, the non-doped spacer portion 22, and the p-type layer 26. Each of the three layers of the active layers 24 disposed at the non-doped spacer portion 22 can be constituted by, for example, a multi-quantum well that includes four layers of quantum wells in each of which an InGaAs well layer having a thickness of 8 nm is sandwiched between AlGaAs barrier layers each having a thickness of 10 nm. In this case, twelve layers of quantum wells are included in total in the resonator portion 18. The n-type layer 20, the p-type layer 26, and the other portion of the non-doped spacer portion 22 can be constituted by, an n-type GaAs layer, a p-type GaAs layer, and a non-doped GaAs layer, respectively.

As described above, the resonator portion 18 is constituted by the p-i-n junction, which is present also in a normal VCSEL, and has a configuration similar to the configuration of a resonator portion that includes an active layer in an i-layer. However, the number of layers of quantum wells of the resonator portion 18 is greater than the number (approximately three) of layers of quantum wells of a normal VCSEL. An effective resonator length in the resonator portion 18 is 10 $\mu$m.

The upper DBR layer 28 can be constituted by, for example, twenty pairs of an $Al_{0.1}Ga_{0.9}As$ layer and an $Al_{0.9}Ga_{0.1}As$ layer, each having an optical film thickness of 1/4 $\lambda$c, that are laminated as a laminated body. The oxidized constriction layer 38 in which a portion of an $Al_{0.98}Ga_{0.02}As$ layer having a thickness of 30 nm is oxidized is provided in the upper DBR layer 28. The oxidized constriction layer 38 can be formed by, for example, oxidizing an $Al_{0.98}Ga_{0.02}As$ layer from side surfaces of the mesa by water vapor during manufacture. The oxidized constriction layer 38 includes a non-oxidized portion at a center portion of the mesa and an oxidized portion in the vicinity of a side wall of the mesa. The oxidized constriction layer 38 causes electric current that is injected into the light emitting element 1100 to flow through only the non-oxidized portion. Therefore, laser oscillation occurs at only at a portion overlapping the center portion of the mesa in plan view in the light emitting element 1100.

Note that it may be configured such that a laser beam generated by the light emitting element 1100 is emitted from the side of the upper DBR layer 28 or emitted from the side of the semiconductor substrate 10.

The light emitting element 1100 of the comparative example is based on the configuration of a normal VCSEL and includes the following three elements additionally. The first one of the three elements added to the VCSEL is to substantially increase the volume of the active layers. For example, a normal VCSEL is constituted by three layers of quantum wells. However, the quantum wells are increased to approximately twenty layers in terms of volume of the quantum wells. The second one is to introduce the saturable absorption layer 16. The third one is to extend the effective resonator length as a VCSEL. The effective resonator length is a resonator length sensed by light in a resonator. More specifically, the effective resonator length is an average value of distances that light transmitted through the active layers in a resonance direction propagates after being reflected by two reflecting mirrors constituting a resonator until the light is transmitted through the active layers again. By adding at least one, preferably, three of these elements, it is possible to achieve a VCSEL that can generate an optical pulse having a high peak value and a short pulse width.

In the light emitting element 1100 of the comparative example, oscillation starts approximately 600 ps after injection of electric current is started. Reasons for a delay in start of oscillation compared with a normal VCSEL are the increased effective volume of the active layers 24 and inhibition of oscillation due to light absorption in the saturable absorption layer 16 in a certain period of time from injection start of electric current. When light is absorbed into the saturable absorption layer 16, the absorbed light is accumulated as carriers in the saturable absorption layer 16. When the number of carriers increases along with absorption of light and a carrier density in the saturable absorption layer 16 reaches a transparent carrier density the saturable absorption layer 16 stops absorbing light. As a result, an effect that inhibits laser oscillation is lost, and the light emitting element starts laser oscillation.

An object of inhibiting laser oscillation by the saturable absorption layer 16 for a certain period of time is to accumulate carriers at more than a threshold carrier density in the active layers 24. Here, the threshold carrier density is a carrier density with which a gain that is required for laser oscillation is generated.

The carrier density of the active layers 24 starts to increase with electric current being started to be injected. In a state before laser oscillation starts, carriers temporality exceed the threshold carrier density and continue to accumulate. Thereafter, when laser oscillation starts, carriers are suddenly consumed by induced emission and are settled at a stable value. Consequently, an optical pulse having a high peak value and a short half-value width can be output.

Since the saturable absorption layer 16 suppresses laser oscillation for a certain period of time, it is possible to accumulate carriers at more than or equal to the threshold carrier density in the active layers 24. As a result of such a high carrier density being achieved, an optical pulse having a high peak value and a short pulse width can be generated inside the light emitting element after oscillation.

A condition for laser oscillation to continue after an optical pulse is generated is that a maximum gain obtained by the active layers 24 exceeds absorption in the resonator as a whole. Specifically, when the relationship expressed by Expression (1) below is satisfied, it is possible to continue laser oscillation. In Expression (1), Гa represents the light confinement coefficient of the saturable absorption layer 16, Гs represents the light confinement coefficient of the active layers 24, and gmax(Iop) represents a maximum gain obtained in the active layers 24 when the electric current value is Iop.

In addition, $\alpha2$ is the absorption coefficient of the saturable absorption layer 16, $\alpha m$ is a mirror loss, and $\alpha i$ is light absorption by carriers and the like of semiconductors.

$$\Gamma s \times gmax(Iop) > \Gamma a \times \alpha2 + \alpha m + \alpha i \quad \dots(1)$$

Problems in Comparative Example

In Fig. 9B, an electric-current injection path in the comparative example is illustrated. An electron is injected from the electrode 40, and the electron is injected into the active layers 24 through the n-type layer 20. On the other hand, a hole is injected from the electrode 42, and the hole is injected into the active layers 24 through the p-type upper DBR layer 28 and the p-type layer 26.

When the electrode 40 is thus provided adjacent to the mesa structure, the size of the light emitting element increases with an increase in the size of the electrode 40. As a result, when a plurality of light emitting elements are arranged as an array, narrowing the pitch of the light emitting elements may be difficult. In addition, when the light emitting elements are arranged as an array, routing of a wire that is electrically connected to the electrode 40 may be difficult.

First Embodiment

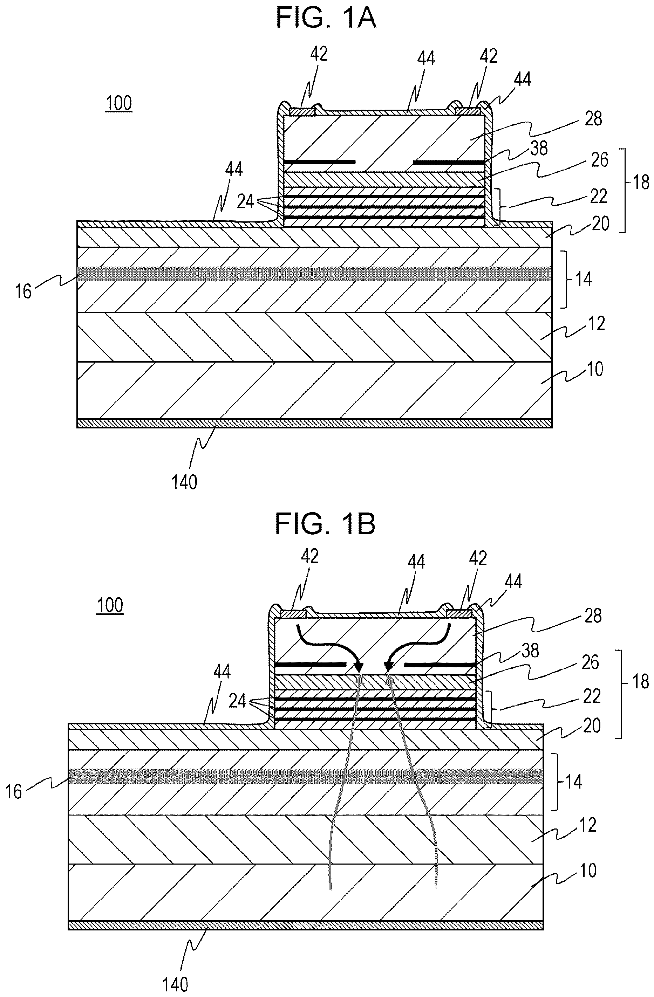

Fig. 1A is a schematic sectional view illustrating a structure of a light emitting element in a first embodiment. Differently from the comparative example, a back electrode 140 (first electrode) is provided below the lower DBR layer 12, which is the back side of the light emitting element.

The same components as those of the light emitting element of the comparative example are given identical reference signs, and description thereof will be omitted or simplified.

Fig. 1B illustrates an electric-current injection path in the first embodiment. Carriers from the electrode 42 (second electrode) and the back electrode 140 (first electrode) move in the up-down direction in semiconductor layers to be injected into active layers. According to the light emitting element of the first embodiment, differently from the comparative example, carriers are not required to be injected in the horizontal direction through the n-type layer 20. Therefore, an area for disposing the electrode 40 is not required to be ensured, which enables size reduction of the light emitting element. Note that, although the size of the light emitting element can be reduced according to the present embodiment, the size of the light emitting element illustrated in Figs. 1A and 1B is not reduced.

In addition, such a configuration also has the following benefit as a secondary effect. Specifically, there is a possibility that variation in the thickness of the n-type layer 20 is generated among the elements in etching in a step of forming a mesa structure. In a configuration in which carriers are injected in the horizontal direction through the n-type layer 20 as in the comparative example, variation in the thickness of the n-type layer 20 causes variation in electric resistance. In particular, when a plurality of elements are arranged as an array, there is a possibility that distribution of electric resistance is generated even when the distance between each element and each electrode 40 is uniformed. In contrast, according to the light emitting element of the first embodiment, variation in electric resistance can be suppressed compared with the comparative example.

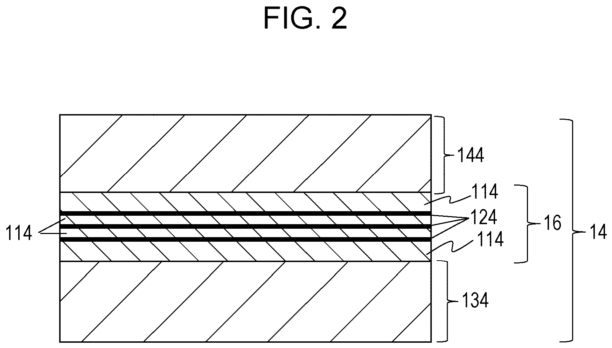

Fig. 2 is a schematic sectional view specifically illustrating semiconductor layers that constitute the spacer portion 14. The saturable absorption layer 16 is constituted by a multi-quantum well in which a quantum well layer 124 is sandwiched between barrier layers 114. The saturable absorption layer 16 is sandwiched between a lower spacer layer 134 (first spacer layer) and an upper spacer layer 144 (second spacer layer), thereby constituting the spacer portion 14. The quantum well layer 124 is made of, for example, InGaAs, the barrier layers 114 are made of, for example, GaAs, and the lower spacer layer 134 and the upper spacer layer 144 are each made of, for example, AlGaAs.

The barrier layers 114 may be made of AlGaAs instead of GaAs. However, using GaAs for a barrier layer can reduce the band gap of the barrier layer compared with when AlGaAs is used. As a result, it becomes possible to accumulate carriers also in the barrier layer made of GaAs, and it is thus possible to easily increase the amount of required carriers. Consequently, the number of layers of the quantum well layers can be reduced. A preferable condition for accumulating carriers in a barrier layer is that an energy difference between energy (in other words, the band gap of an active layer) of a photon of an oscillation wavelength and the band gap of the barrier layer is 230 meV or less. Here, in the aspect of reducing light absorption by semiconductors that constitute a barrier layer, an energy difference with respect to the band gap thereof is desirably a specific value or more. In the present embodiment, a suitable condition when the material of the barrier layers is GaAs will be examined. The absorption coefficient of GaAs has wavelength dependence, and light extraction efficiency calculated using this wavelength dependence is indicated next.

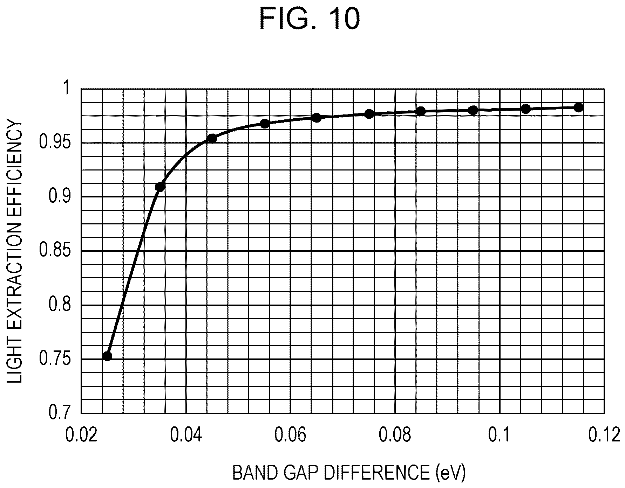

Fig. 10 is a graph indicating a relationship between light extraction efficiency and band gap difference. The vertical axis represents light extraction efficiency, and the horizontal axis represents band gap difference. The band gap difference is a band gap difference between a barrier layer and a quantum well layer. The light extraction efficiency when light is not absorbed by GaAs is set to 1. In the graph, values with the band gap differences of 25, 35, 45, 55, 65, 75, 85, 95, 105, and 115 meV are shown. When the band gap difference is 105 meV, light extraction efficiency decreases by 2% compared with a case where absorption due to a band gap does not occur. Similarly, when the band gap difference between a barrier layer and a quantum well layer is 60 meV, 48 meV, and 44 meV, light extraction efficiency decreases by 3%, 4%, and 5%, respectively, compared with a case where absorption due to a band gap does not occur. Note that the case where absorption due to a band gap does not occur is a case where light extraction efficiency is 1.

The difference between 105 meV at which light extraction efficiency is decreased by 2% and 60 meV at which light extraction efficiency is decreased by 3% is 45 meV. The difference between 60 meV at which light extraction efficiency is decreased by 3% and 48 meV at which light extraction efficiency is decreased by 4% is 12 meV. The difference between 48 meV at which light extraction efficiency is decreased by 4% and 44 meV at which light extraction efficiency is decreased by 5% is 4 meV. That is, as the light extraction efficiency is decreased, the difference decreases.

Here, controllability of elemental composition during crystal growth is said to be approximately 1% in tertiary and higher-order compound semiconductors. The changing amount of the band gap when the composition is changed by 1% is 12 meV with an AlGaAs-based material and 14 meV with an InGaAs-based material. It can be found that the energy difference is similar between a case where these compositions are changed by 1% and a case where the light extraction efficiency described above is changed from 3% to 4%. As described above, in consideration of the composition changing amount of 1% during crystal growth, the band gap difference is preferably 60 meV or more corresponding to a design value at which the decrease in the light extraction efficiency is 3%. By designing to such a value, it becomes possible to maintain characteristic stability of elements even when a manufacture error during crystal growth is generated.

From the above, a suitable range of the band gap difference will be examined in consideration of an aspect of causing carriers to be present in barrier layers and an aspect of reducing light absorption in the barrier layers. To suppress decrease in light extraction efficiency to be 2% or less with a high priority being put on reduction of the impact of light absorption at a band edge, the band gap difference is preferably in the range of 105 meV to 230 meV. With such a range, the light extraction efficiency of the element improves.

In addition, when decrease by approximately 4% in light extraction efficiency by light absorption at the band edge is allowable, the band gap difference is preferably in the range of 60 meV to 230 meV in consideration of also controllability during crystal growth. With such a range, the characteristic stability of the elements improves.

Note that, even when a compound semiconductor material that differs from those in the present embodiment is used, the above-described numerical values are applicable if the compound semiconductor material is a semiconductor material of a direct transition type since wavelength dependence of the absorption coefficient thereof with respect to wavelengths lower than or equal to the band gap is not significantly different.

A configuration in which carriers are actively accumulated in barrier layers provides also a secondary effect in addition to the above-described effect. A first effect is that it is possible to reduce cumulative distortion of semiconductor layers. When assuming that the oscillation wavelength is set to 940 nm, an active layer is an InGaAs active layer and a substrate is a GaAs substrate, and thus, distortion due to a lattice constant difference is generated in the active layer that is grown on the substrate. Then, as the number of quantum well layers increases, the cumulative distortion increases. Therefore, design in which the band gap of barrier layers is reduced and the number of quantum well layers is reduced as in the present embodiment has an effect that it is possible to reduce cumulative distortion. This effect is not a specific effect that can be obtained when the oscillation wavelength is 940 nm and is an effect that can be commonly obtained when the lattice constant of the constituent material of the substrate differs from the lattice constant of the constituent material of the active layer or the like that is formed thereon by crystal growth.

A second effect is that it is possible to reduce consumption of carriers by radiative recombination. In all of semiconductors that include quantum well layers or barrier layers, when carriers of both a hole and an electron are present at the same time, the carriers are consumed by radiative recombination (spontaneous emission). In a semiconductor laser, when consumption of carriers by radiative recombination (spontaneous emission) increases, the threshold of laser oscillation increases and efficiency of power conversion decreases, which is not preferable. It is known that this radiative recombination is proportional to the square of carrier density. Therefore, even when the amount of the carriers to be accumulated is the same, the carrier density, in other words, the amount of carriers consumed by radiative recombination varies depending on the volume of a portion where the carriers are accumulated.

Further, the non-doped spacer portion 22, which functions as an active layer, can have the same configuration. Specifically, in the configuration, the quantum well layer is an InGaAs quantum well layer, the barrier layers around the quantum well layer are GaAs barrier layers, and the band gap difference between the two layers are 230 meV or less. A preferable lower limit of the band gap is also the same as the lower limit described above. With such a configuration, at least one of the following multiple effects can be obtained. The multiple effects are an effect that it is possible to increase carriers that accumulate in the active layer, an effect that it is possible to reduce the number of quantum wells required for accumulating a required number of carriers in the active layer, an effect that it is possible to reduce the amount of the accumulated carriers consumed by radiative recombination, and an effect that it is possible to reduce cumulative distortion. Specifically, with this configuration, the total number of quantum well layers can be reduced from 12 to about 4. In addition, the energy of an optical pulse can be increased by increasing the peak value of the optical pulse immediately after oscillation is started. Note that a preferable range of the band gap difference between quantum well layers and barrier layers when this configuration is used for the active layer is the same as that when this configuration is used for the spacer portion 14 described above. However, the non-doped spacer portion 22 and the spacer portion 14 are not essential requirements for exerting the effects in the present disclosure, although the above-described configuration in which the band gap difference is set to 230 meV or less is a preferable configuration. For example, even when the non-doped spacer portion 22 is configured as in the comparative example, the effects in the present disclosure are exerted.

As described above, in the light emitting element of the first embodiment, carriers are moved in the up-down direction by providing the back electrode 140 on the back side. Therefore, the semiconductor substrate 10, the lower DBR layer 12, and the spacer portion 14 are all constituted by n-type semiconductor materials. That is, the lower spacer layer 134, the barrier layers 114, the quantum well layer 124 (the saturable absorption layer 16), and the upper spacer layer 144, which constitute the spacer portion 14, are all n-type semiconductors. However, since there is a possibility that a lattice defect is introduced into the quantum well layer 124 when an impurity is doped, the quantum well layer 124 may be a non-doped semiconductor layer.

In the aforementioned example, the spacer portion 14 is used to increase the distance between the lower DBR layer 12 and the upper DBR layer 28, thereby increasing the resonator length as a laser. The object thereof is to widen the pulse width. It is desirable that the optical thickness of the resonator spacer portion is more than or equal to five times a resonant wavelength, more preferably, more than or equal to eleven times the resonant wavelength. Note that the optical thickness denotes a value that is obtained by multiplying a physical thickness by a refractive index of the medium.

In addition, although the effective resonator length is increased by increasing the physical distance between the lower DBR layer 12 and the upper DBR layer 28 with the film thickness of the spacer portion 14 or the like being increased in the aforementioned example, the method of increasing the effective resonator length is not limited thereto. For example, it is possible to effectively extend the resonator length, even in a configuration in which the distance between the lower DBR layer 12 and the upper DBR layer 28 is shorter than in the present embodiment, by providing a third reflecting mirror between the lower DBR layer 12 and the upper DBR layer 28 to form a coupled resonator.

In addition, the optical thickness of the spacer portion 14 may be set to, for example, an integer multiple of $\lambda/2$, and a pair of semiconductor layers having different refractive indexes and each having an optical thickness of, for example, $\lambda/4$ may be laminated on the spacer portion 14. In this case, the spacer portion 14 is a portion of the lower DBR layer 12, and it can be said that the spacer portion 14 is included in the lower DBR layer 12. The present embodiment does not exclude such a configuration.

Note that, regarding matters common among the comparative example, the first embodiment, and the following embodiments, the matters described for the comparative example are also applicable to these embodiments.

Second Embodiment

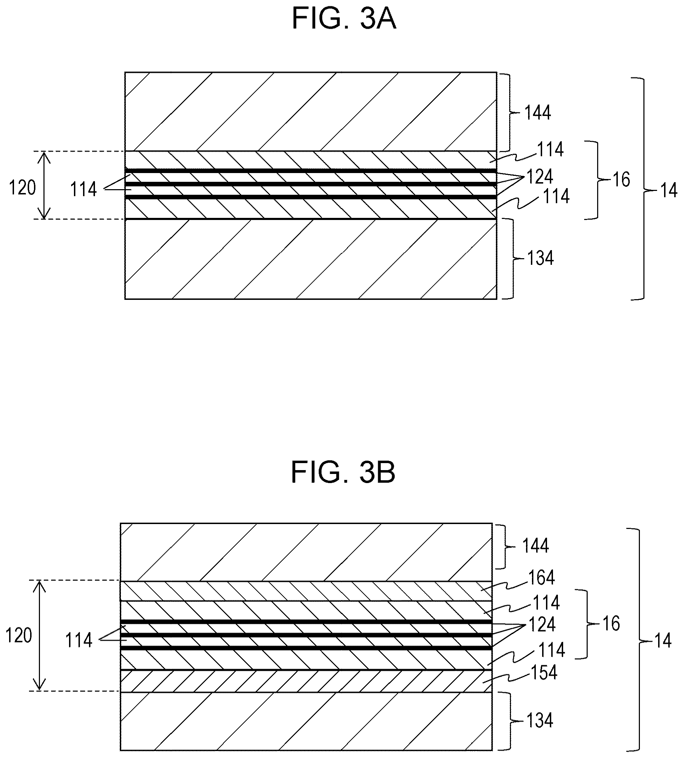

A light emitting element according to a second embodiment will be described with Figs. 3A and 3B. Figs. 3A and 3B are schematic sectional views illustrating a structure of the spacer portion 14 of the light emitting element according to the present embodiment.

While all of the semiconductor layers constituting the spacer portion 14 are n-type semiconductors in Fig. 2, semiconductor layers constituting the saturable absorption layer 16 are each made of a non-doped semiconductor material and the lower spacer layer 134 and the upper spacer layer 144 are n-type semiconductors in Fig. 3A. That is, a region 120 in Fig. 3A is a non-doped semiconductor region.

According to the light emitting element in the present embodiment, it is possible to further reduce the size of the light emitting element than in the comparative example. Secondarily, it is possible to suppress variation in electric resistance.

When an impurity is doped into the saturable absorption layer 16, there is a possibility that a lattice defect is generated and causes a decrease in light emission efficiency. Therefore, according to the second embodiment, it is possible to suppress a decrease in light emission efficiency compared with the first embodiment.

As illustrated in Fig. 3B, a non-doped semiconductor layer 154 may be provided between the saturable absorption layer 16 and the lower spacer layer 134. In addition, a non-doped semiconductor layer 164 may be provided, on the opposite side, between the saturable absorption layer 16 and the upper spacer layer 144. In this case, the region 120 in Fig. 3B is a non-doped semiconductor region. Further, only the non-doped semiconductor layer 154 or the non-doped semiconductor layer 164 may be provided. The non-doped semiconductor layers 154 and 164 are, for example, non-doped AlGaAs semiconductor layers.

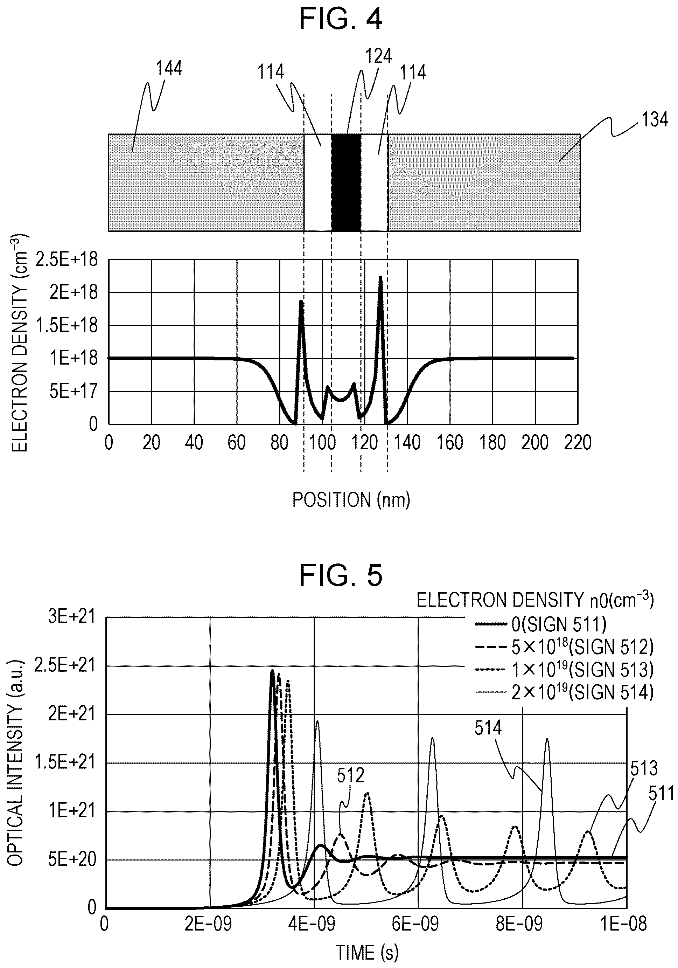

Fig. 4 is a calculation example of electron density. The quantum well layer 124 is a non-doped InGaAs quantum well layer, the barrier layers 114 are non-doped GaAs barrier layers, and the lower spacer layer 134 and the upper spacer layer 144 are n-type AlGaAs spacer layers. The film thickness of the quantum well layer 124 is 16 nm, the film thickness of each of the barrier layers 114 is 10 nm, and impurity concentration of the n-type AlGaAs layers, which are the lower spacer layer 134 and the upper spacer layer 144, is $1 \times 10^{18}$ cm$^{-3}$. In this calculation, two layers of quantum wells are calculated as one layer of the quantum well layer 124 to simplify the calculation.

Fig. 4 is a calculation example when a forward-bias is applied to a device, and the electron density from the lower spacer layer 134 side to the upper spacer layer 144 is a predetermined value or more. Consequently, it can be confirmed that an electron injected from the lower spacer layer 134 side is injected into the upper spacer layer 144 through the barrier layer 114 on the lower side, the quantum well layer 124, and the barrier layer 114 on the upper side.

The thickness of the non-doped region 120 is required to be a thickness with which the carriers from the lower spacer layer 134 are sufficiently diffused. A preferable thickness will be described later.

A carrier consumption speed Rc in the quantum well layer is expressed by Expression (1) below.

$$Rc = B \times (n0 + n1) \times p1 \cdots (1)$$

Here, B represents a physical constant, n0 represents an electron density in a non-operating state of the light emitting element, n1 represents an electron density increased during operation of the light emitting element, and p1 represents a hole density increased during operation of the light emitting element. When Rc increases, carriers are consumed in the quantum well layers, resulting in a state in which laser oscillation is not continued. Therefore, n0 is required to be designed not to be a great value.

Fig. 5 is a graph indicating a relationship between the electron density n0 in the well layer and optical response waveform. Fig. 5 illustrates change in optical intensity with respect to time. When the electron density n0 is 0 cm$^{-3}$, as indicated by the sign 511, a waveform is such that, after a peak that indicates a high peak value is shown, laser oscillation continues and the value is settled at a stable value. Next, also when the electron density n0 is $5 \times 10^{18}$ cm$^{-3}$, as indicated by the sign 512, a waveform is such that, after a peak indicating a high peak value is shown, laser oscillation continues and the value is settled at a stable value. The light emitting element emits light that has a maximum peak value and that has a profile of being settled at a stable value that is predetermined optical intensity after the maximum peak value. Next, when the electron density n0 is $1 \times 10^{19}$ cm$^{-3}$, as indicated by the sign 513, after a peak indicating a high peak value is shown, laser oscillation temporarily stops and thereafter a peak is shown again. Afterwards, such a peak is periodically shown. This is called self-pulsation. Next, also when the electron density n0 is $2 \times 10^{19}$ cm$^{-3}$, as indicated by the sign 514, after a peak indicating a high peak value is shown, laser oscillation temporarily stops and thereafter a peak is shown again. Afterwards, such a peak is periodically shown. It is difficult to handle, as a light source, the self-pulsation showing a plurality of peaks during a period in which electric current flows. Therefore, the value of the electron density n0 is required to be set such that the self-pulsation does not occur.

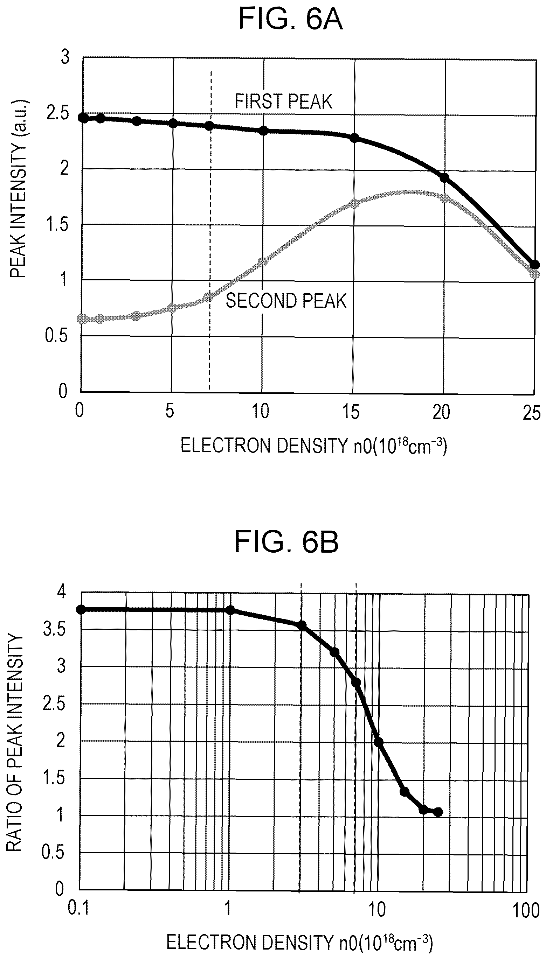

Figs. 6A and 6B are graphs indicating how the optical intensity at the first peak and the optical intensity at the second peak, which are illustrated in Fig. 5, change depending on the value of the electron density n0. Referring to Fig. 5, it is found that as the ratio of the optical intensity at the second peak relative to the optical intensity at the first peak decreases, the self-pulsation occurs more easily.

Fig. 6B indicates the ratio of the optical intensity at the second peak relative to the optical intensity at the first peak. When the electron density n0 is higher than $7 \times 10^{18}$ cm$^{-3}$, the variation ratio relating to the ratio of the peak intensity relative to the electron density is considerably increased. Therefore, the electron density n0 is preferably set to $7 \times 10^{18}$ cm$^{-3}$ or less. In addition, when the electron density n0 is higher than $3 \times 10^{18}$ cm$^{-3}$, the variation ratio relating to the ratio of the peak intensity relative to the electron density increases. Therefore, the electron density n0 is preferably set to $3 \times 10^{18}$ cm$^{-3}$ or less.

Incidentally, regarding the calculation example illustrated in Fig. 4, calculation is performed under a condition in which the quantum well layer 124 and the barrier layers 114 are n-type semiconductor layers and in which the impurity concentration is the same in the quantum well layer 124, the barrier layers 114, the lower spacer layer 134, and the upper spacer layer 144. That is, this condition is a calculation example of the first embodiment. Through the calculation, it is found that, to cause the electron density n0 in the quantum well layers to be $7 \times 10^{18}$ cm$^{-3}$ or less, the n-type doping concentration of these layers is set to $5.6 \times 10^{18}$ cm$^{-3}$ or less. From this result, the doping concentration of the saturable absorption layer 16 is set to $5.6 \times 10^{18}$ cm$^{-3}$ or less in the first embodiment to suppress occurrence of self-pulsation.

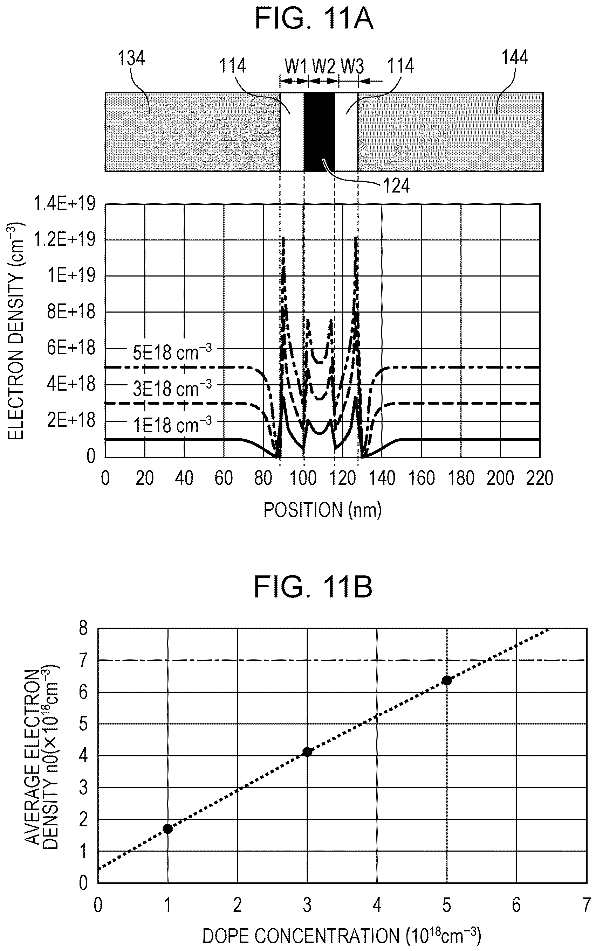

Fig. 11A is a graph indicating results of calculation of electron density. Fig. 11A illustrates results of calculation when the doping concentration is the same among the quantum well layer 124, the barrier layers 114, the lower spacer layer 134, and the upper spacer layer 144. In the graph, the vertical axis represents electron density (cm$^{-3}$), and the horizontal axis represents position (nm). The carriers are electrons. A diagram in which positions of the quantum well layer 124, the barrier layers 114, the lower spacer layer 134, and the upper spacer layer 144 are schematically illustrated is illustrated above the graph. The width of the barrier layer 114 on the lower side is represented by W1, the width of the quantum well layer 124 is represented by W2, and the width of the barrier layer 114 on the upper side is represented by W3.

Fig. 11B indicates electron density n0 of the quantum well layer 124 read from Fig. 11A and the doping concentration ($10^{18}$ cm$^{-3}$). Here, the electron density n0 is an average value. In Fig. 11B, it is found that the electron density n0 has doping concentration dependence.

Setting the electron density n0 in the quantum well layers to $7\times10^{18}$ cm$^{-3}$ or less as described above can be achieved by setting n-type doping concentration of these layers to $5.6\times10^{18}$ cm$^{-3}$ or less. Setting the electron density n0 in the quantum well layers to a more preferable electron density of $3\times10^{18}$ cm$^{-3}$ can be achieved by setting n-type doping concentration to $2.1\times10^{18}$ cm$^{-3}$ or less.

Meanwhile, the lower limit value of preferable doping concentration in an aspect of manufacture is $1\times10^{16}$ cm$^{-3}$. This is because control of electron density of $1\times10^{16}$ cm$^{-3}$ or less is difficult. By taking such a lower limit value into consideration, it is possible to improve characteristic stability.

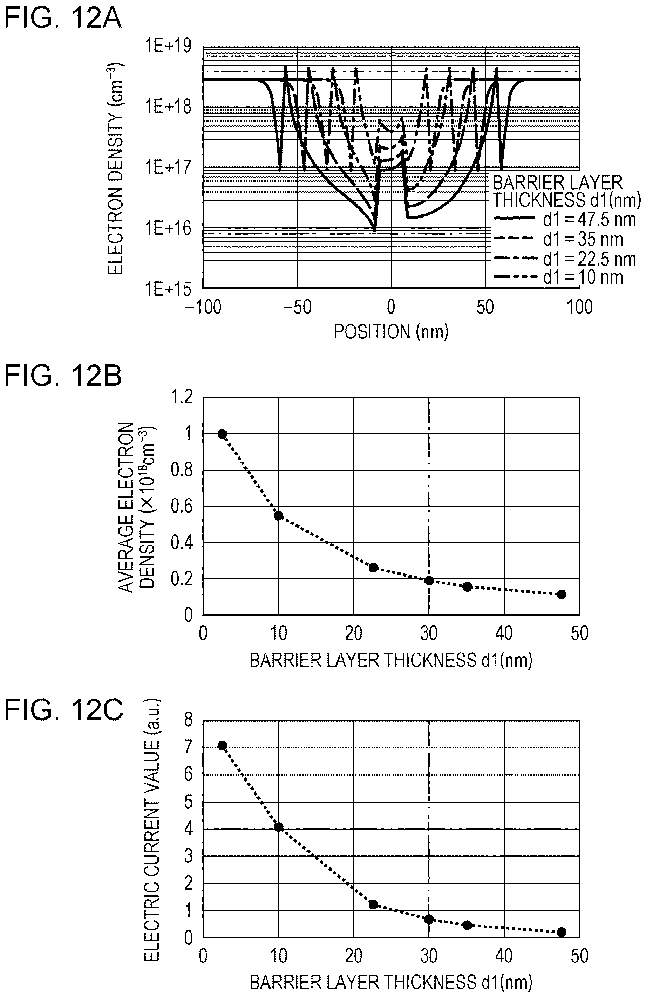

The spacer portion 14 in the second embodiment is as follows. The spacer portion 14 in the second embodiment includes a lower spacer layer 134 and an upper spacer layer 144. Figs. 12A, 12B, and 12C illustrate change in the electron density n0 of the quantum well layer 124 in the non-doped region 120 due to the doping concentration of the lower spacer layer 134 and the upper spacer layer 144. Figs. 12A, 12B, and 12C illustrate doping concentration and electron density of the spacer layers. The vertical axis represents electron density (cm$^{-3}$) and the horizontal axis represents position (nm). In Figs. 12A, 12B, and 12C, it is found that, even when the doping concentration of each of the lower spacer layer 134 and the upper spacer layer 144 changes to $5.0\times10^{18}$ cm$^{-3}$, the electron density of the quantum well layer 124 is $5\times10^{17}$ cm$^{-3}$, which is in the preferable range indicated in Figs. 6A and 6B. Then, even when the doping concentration of each of the lower spacer layer 134 and the upper spacer layer 144 changes, the electron density n0 of the quantum well layer 124 does not change significantly. As described above, the electron density of the quantum well layer 124 affects optical pulse characteristics as shown in Fig. 5 and Figs. 6A and 6B. Therefore, even when the doping concentration of each of the lower spacer layer 134 and the upper spacer layer 144 changes in the spacer portion 14 in the second embodiment, the change in the optical pulse characteristics can be reduced with respect to doping concentration variation in manufacture since the amount of change in the electron density n0 of the quantum well layer 124 is small.

Fig. 12A is a graph indicating results of calculation of the electron density n0. The horizontal axis represents position as in Fig. 11. Here, the electron density n0 in the quantum well layer 124 when a thickness d1 of a barrier layer disposed between a doped layer and the quantum well layer 124 is changed in the spacer portion 14 in the second embodiment is indicated. It is found that as the thickness d1 of the barrier layer increases, the electron density of a non-doped portion decreases. Then, when the thickness d1 of the barrier layer is 47.5 nm, the lowest electron density is approximately $1\times10^{16}$ cm$^{-3}$. In general, control of electron density of $1\times10^{16}$ cm$^{-3}$ or less is difficult in a compound semiconductor made of GaAs or the like. When the thickness d1 of the barrier layer is increased to be larger than 47.5 nm, carriers are compensated by holes that are unintentionally generated during manufacture and electrons, and a region in which the number of the holes is greater may be generated in some cases. In other words, control of element characteristics becomes difficult. Therefore, the thickness d1 of the barrier layer is preferably 47.5 nm or less.

Fig. 12B is a graph indicating a relationship between the electron density n0 (average value) in the quantum well layer 124 and the thickness d1 of the barrier layer. The vertical axis represents the electron density in the quantum well layer, and the horizontal axis represents change in the thickness d1 of the barrier layer. It is found that, even when the thickness d1 is 2.5 nm, the electron density is $7\times10^{18}$ cm$^{-3}$ or less, which is preferable from the aspect of the optical pulse waveform illustrated in Fig. 5 to Fig. 7 described above. Therefore, the thickness d1 of the barrier layer is preferably 2.5 nm or more.

Fig. 12C is a graph indicating a relationship between electric current that flows through the spacer portion 14 and the thickness d1 of the barrier layer. This graph is obtained by calculating electric current that flows through the spacer portion 14 when a potential difference of 0.1 V is applied to both ends of the spacer portion 14. It can be confirmed that electric current flows when the thickness d1 of the barrier layer is 47.5 nm or less, and an effect, which is an effect of the spacer portion 14 in the second embodiment, that it is possible to cause electric current to pass through the barrier layer while the barrier layer is kept undoped can be confirmed. Further, when the thickness d1 of the barrier layer is reduced to be less than 30 nm, the increasing rate (slope on the graph) of electric current increases. Therefore, when the thickness d1 of the barrier layer is set to be 30 nm or less, it is possible to cause a greater amount of electric current to pass through the barrier layer, which is more preferable.

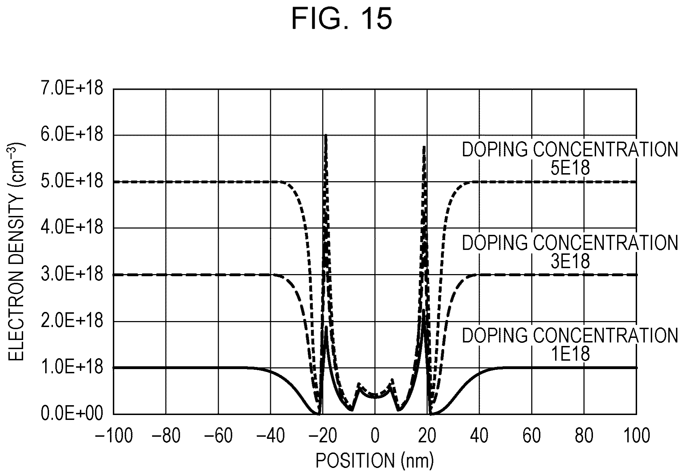

Fig. 15 is a calculation example of electron density of the spacer layer of the light emitting element. FIG. 15 shows the electron density of the spacer layer for the structure with d1 = 10 nm in FIG. 12A, where the doping concentrations of the lower spacer layer 134 and the upper spacer layer 144 are varied. Calculations when doping concentration is $5\times10^{18}$ cm$^{-3}$, when doping concentration is $3\times10^{18}$ cm$^{-3}$, and when doping concentration is $1\times10^{18}$ cm$^{-3}$ are shown. From these results, it can be seen that the electron density of the quantum well layer does not change even when the doping concentrations of the lower spacer layer 134 and the upper spacer layer 144 are changed. In other words, the electron density of the quantum well layer is determined by the structures of the barrier layer and the quantum well layer.

Taking the effect of the spacer portion 14 in the second embodiment into consideration, the range of the thickness d1 of the barrier layer is 2.5 nm to 47.5 nm, preferably, 2.5 nm to 30 nm. With the thickness d1 in such a range, it becomes easy to cause electric current to pass through the barrier layer while the barrier layer is kept undoped. In addition, the thickness d1 of the barrier layer may be different between the barrier layer above the quantum well layer and the barrier layer below the quantum well layer. In such a case, the thickness d1 of each of the barrier layers is preferably in the range described above.

Materials and doping concentration may be the same or may be different among the barrier layers, the lower spacer layer 134, and the upper spacer layer 144 in the first embodiment and the second embodiment. In addition, a structure in which at least one of the lower spacer layer 134 and the upper spacer layer 144 is omitted may be employed.

Regarding consumption of carriers in Expression (1) above, only the event of radiative recombination is considered in the calculation. Meanwhile, in actual semiconductors, however, semiconductor defects may be generated due to a condition for crystal growth or due to addition of a dopant. Some types of semiconductor defects cause non-radiative recombination to occur. In such a case, consumption of carriers increases, and self-pulsation tends to occur at n0, which is lower than that indicated in the calculation example in Fig. 4.

In addition, the mobility of electrons in a non-doped semiconductor is faster than the mobility of electrons in a doped semiconductor. For example, the mobility in non-doped GaAs is equal to or more than twice the mobility in GaAs that is doped to $1\times10^{18}$ cm$^{-3}$. Therefore, the second embodiment has a benefit that, while the electron density n0 is suppressed to be low, the high mobility makes it possible to reduce electric resistance.

A modification of the present embodiment is a configuration in which the non-doped region 120 illustrated in Figs. 3A and 3B is doped with a sufficiently low concentration. From Expression (1) and Fig. 5, it can be understood that similar effects are exerted when the electron density generated by doping is sufficiently low. Here, in comparison between the sign 511 and the sign 512 in Fig. 5, the optical response waveforms are not greatly different from each other, and it is thus possible to perform doping with an impurity such that electron density is $1\times10^{18}$ cm$^{-3}$ or less.

When the non-doped region 120 in Fig. 3A is changed to a low-concentration impurity region, the quantum well layer 124 and the barrier layers 114 are made to be n-type semiconductors in each of which impurity concentration is lower than that in each of the lower spacer layer 134 and the upper spacer layer 144.

When the non-doped region 120 in Fig. 3B is changed to a low-concentration impurity region, the quantum well layer 124 and the barrier layers 114 are made to be n-type semiconductors in each of which impurity concentration is lower than that in each of the lower spacer layer 134 and the upper spacer layer 144. In addition, the semiconductor layer 154 between the saturable absorption layer 16 and the lower spacer layer 134 is made to be an n-type semiconductor in which impurity concentration is lower than that in each of the lower spacer layer 134 and the upper spacer layer 144. Further, the semiconductor layer 164 between the saturable absorption layer 16 and the upper spacer layer 144 is made to be an n-type semiconductor in which impurity concentration is lower than that in each of the lower spacer layer 134 and the upper spacer layer 144. Note that only one of the semiconductor layer 154 and the semiconductor layer 164 may be provided.

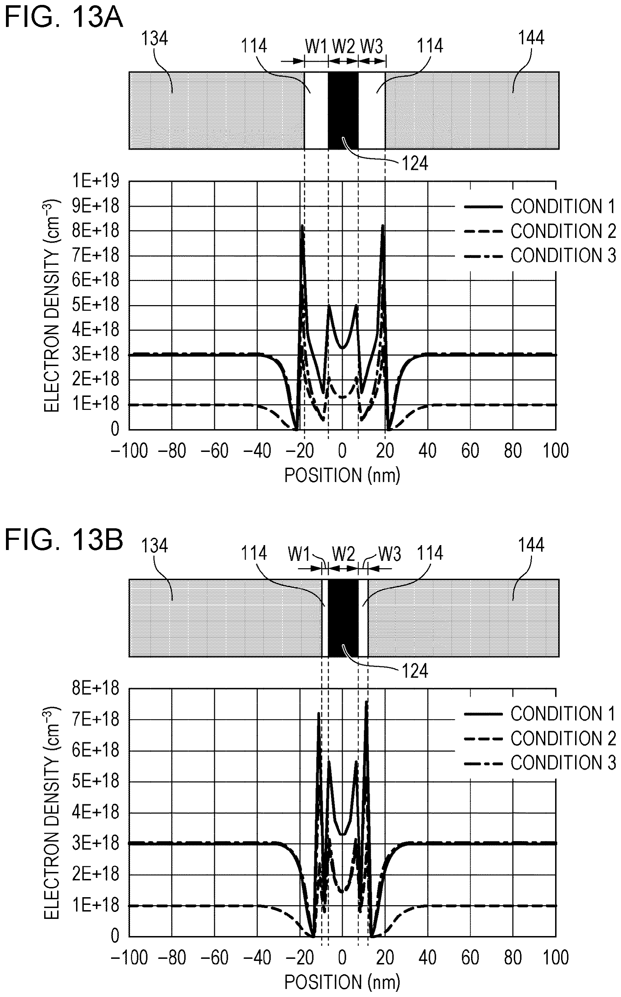

Next, preferable impurity concentration when the non-doped region 120 in Fig. 3A is changed to a low-concentration impurity region will be examined. Figs. 13A and 13B are graphs similar to the graph in Fig. 11A and indicate distribution of electron density (cm$^{-3}$) under three conditions. Among the three conditions, Condition 1 is a situation in which impurity concentration of the entirety of the spacer portion 14 is set to $3\times10^{18}$ cm$^{-3}$, and Condition 2 is a situation in which impurity concentration of the entirety of the spacer portion 14 is set to $1\times10^{18}$ cm$^{-3}$. Condition 3 is a situation in which impurity concentration is set to $3\times10^{18}$ cm$^{-3}$ in each of the lower spacer layer 134 and the upper spacer layer 144 and is set to $1\times10^{18}$ cm$^{-3}$ in each of the quantum well layer 124 and the barrier layers 114. Further, Fig. 13A is a graph when the thickness d1 of the barrier layer is set to 10 nm, and Fig. 13B is a graph when the thickness d1 of the barrier layer is set to 2.5 nm. In Figs. 13A and 13B, W1 and W3 are changed.

In both of the graphs in Fig. 13A and Fig. 13B, the electron density under Condition 2 overlaps the electron density under Condition 3 in the quantum well layer 124. That is, it is found that, when the non-doped region 120 is changed to a low-concentration impurity region, the electron density of the quantum well layer 124 is determined by the doping concentration of each of the quantum well layer 124 and the barrier layers 114 without depending on the film thickness d1 of each barrier layer when the thickness d1 of each barrier layer is 2.5 nm or more. A reason for the electron density of the quantum well layer 124 being less affected by the doping concentration of the lower spacer layer 134 and the upper spacer layer 144 and the thickness of each barrier layer is as follows. The reason is that most of electrons that flow in from the lower spacer layer 134 and the upper spacer layer 144 is present at a location away from the quantum well layer 124, specifically, near the interface between each of the lower spacer layer 134 and the upper spacer layer 144 and the barrier layers.

As another embodiment, a configuration in which the lower spacer layer 134 and the upper spacer layer 144 are each doped more lightly than the quantum well layer 124 and the barrier layers 114 will be described. When the doping concentration of each of the quantum well layer 124 and the barrier layers 114 is set in the aforementioned range, the lower spacer layer 134 and the upper spacer layer 144 may be doped more lightly than the quantum well layer 124 and the barrier layers 114. For example, the concentration of each of the lower spacer layer 134 and the upper spacer layer 144 can be set to $5\times10^{17}$ cm$^{-3}$ while the concentration of each of the quantum well layer 124 and the barrier layers 114 is set to $1\times10^{18}$ cm$^{-3}$. Although a disadvantage that electric resistance of the electric current that flows through the spacer portion 14 increases due to decreased doping concentration of the spacer portion, the effects of the present disclosure are exerted.

In addition, as another embodiment, it is possible to configure such that the quantum well layer 124 is not doped while the barrier layers 114, the lower spacer layer 134, and the upper spacer layer 144 are each doped. In this case, the electron density n0 of the quantum well layer 124 is lower than when each of the quantum well layer 124 and the barrier layers 114 are doped, by an amount due to the quantum well layer that is not doped. Therefore, the preferable electron density n0 of the quantum well layer 124 can be achieved by setting the doping concentration of each of the barrier layers 114 to $5.6 \times 10^{18}$ cm$^{-3}$ or less, more preferably, to $2.1 \times 10^{18}$ cm$^{-3}$ or less. Such a configuration makes it possible to achieve a preferable optical pulse waveform.

It can be understood that, when the non-doped region 120 is changed to a low-concentration impurity region, it is sufficient that the doping concentration of each of the quantum well layer 124 and the barrier layers 114 is set to the doping concentration indicated in Fig. 11B. Specifically, a preferable optical pulse waveform can be achieved by setting the doping concentration of each of the quantum well layer 124 and the barrier layers 114 to $5.6 \times 10^{18}$ cm$^{-3}$ or less, more preferably, to $2.1 \times 10^{18}$ cm$^{-3}$ or less. Note that, the lower limit value of the preferable doping concentration is not present from the aspect of optical pulse waveforms. However, the lower limit value of the preferable doping concentration is $1 \times 10^{16}$ cm$^{-3}$ from the aspect of manufacture.

Third Embodiment

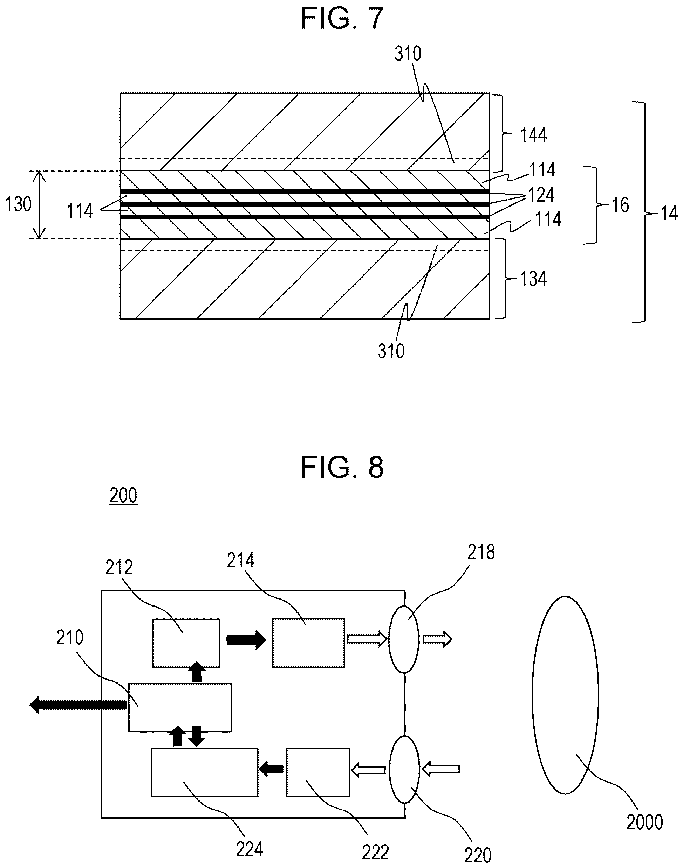

A light emitting element according to a third embodiment will be described with Fig. 7. Fig. 7 is a schematic sectional view illustrating a structure of the light emitting element according to the present embodiment.

The same components as those of the light emitting elements according to the aforementioned embodiments are given identical signs, and description thereof will be omitted or simplified.

In Fig. 7, semiconductor layers constituting the saturable absorption layer 16 are p-type semiconductors, and the lower spacer layer 134 and the upper spacer layer 144 are n-type semiconductors. That is, a region 130 in Fig. 7 is a p-type semiconductor region. Therefore, a junction surface between the saturable absorption layer 16 and the lower spacer layer 134 and a junction surface between the saturable absorption layer 16 and the upper spacer layer 144 each form a depletion layer 310. Specifically, in the saturable absorption layer 16, both the quantum well layer 124 and each barrier layer 114 can be p-type semiconductors.

To form the depletion layers 310 at the entirety of the saturable absorption layer 16 as illustrated in Fig. 7, the impurity concentration of each of the barrier layers 114 constituting the saturable absorption layer 16 is set to be lower than the impurity concentration of each of the lower spacer layer 134 and the upper spacer layer 144. With a forward-bias applied to the light emitting element, carriers can freely pass through the saturable absorption layer 16.

According to the light emitting element in the present embodiment, it is possible to further reduce the size of the light emitting element than in the comparative example. In addition, secondarily, it is possible to suppress variation in electric resistance.

Note that, in the saturable absorption layer 16, the barrier layers 114 can be a p-type semiconductor while the quantum well layer 124 is kept undoped. By keeping the quantum well layer 124 undoped, decrease in the light emission efficiency can be suppressed.

Although a reflecting mirror constituted by a semiconductor is used as a reflecting mirror in each of the first to third embodiments, a DBR in which a dielectric material is used may be employed. However, in such a case, the upper and lower electrodes are disposed to be in electrically contact with a semiconductor portion not via the dielectric DBR since it is not possible to inject electric current through the dielectric DBR even when the upper and lower electrodes are provided on the dielectric material DBR. For example, when at least a portion of the upper DBR layer is formed by a dielectric DBR, the electrodes are disposed to be in electrically contact with a semiconductor layer present below the upper DBR layer. In this case, it can be expressed such that the upper electrode 42 is disposed, at an upper portion of the resonator portion, between the resonator portion and the dielectric DBR.

Fourth Embodiment

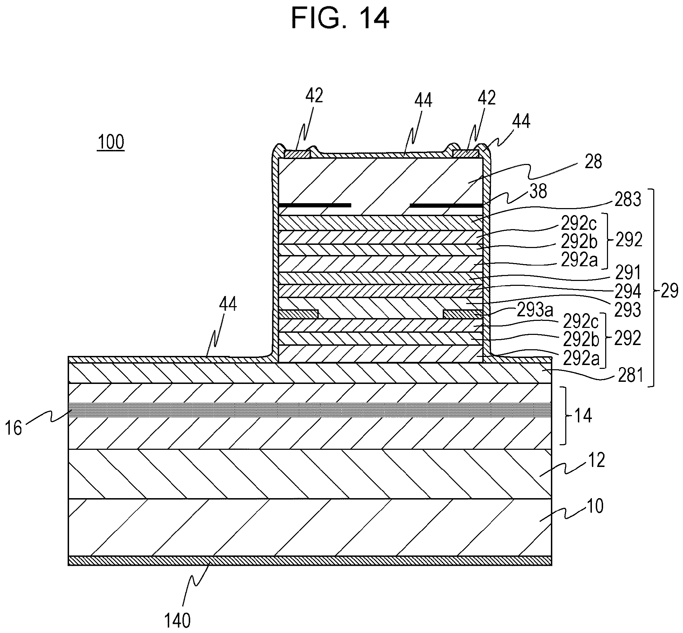

In the above-described embodiments, a configuration having a single p-i-n structure in the resonator portion, which is commonly known as a single junction type, has been described. The present disclosure is, however, not limited thereto. In the present embodiment, a configuration of a multiple junction type having a plurality of p-i-n structures in a resonator portion 29 will be described. Fig. 14 is a schematic sectional view illustrating a light emitting element of the present embodiment. The light emitting element of the present embodiment is of a type, commonly known as a 2-junction type, having two p-i-n junctions in the resonator portion 29.

Fig. 14 illustrates a configuration that is the same, other than the resonator portion 29, as the configuration illustrated in Fig. 1A. The light emitting element in Fig. 14 includes the back electrode 140, the semiconductor substrate 10, the lower DBR layer 12, the spacer portion 14, the resonator portion 29, the upper DBR layer 28, the electrode 42, and a protective layer 44 that are disposed in this order. The spacer portion 14 includes the saturable absorption layer 16. The upper DBR layer 28 includes the oxidized constriction layer 38.

The resonator portion 29 in the present embodiment includes an n-type layer 281, a non-doped spacer portion 292, a p-type layer 293, a tunnel junction layer 294, an n-type layer 291, another non-doped spacer portion 292, and a p-type layer 283. The n-type layer 281, the non-doped spacer portion 292, the p-type layer 293, the tunnel junction layer 294, the n-type layer 291, the other non-doped spacer portion 292, and the p-type layer 283 are disposed in this order from the side near the saturable absorption layer 16.

The n-type layer 281 contains n-type n AlGaAs, the p-type layer 293 contains p-type AlGaAs, the n-type layer 291 contains n-type AlGaAs, and the p-type layer 283 contains p-type AlGaAs. The p-type layer 293 includes an oxidized constriction layer 293a, which is an $Al_{0.98}Ga_{0.02}As$ layer having a thickness of 30 nm. The p-type layer 293 does not necessarily include the oxidized constriction layer 293a.

Each of the two non-doped spacer portions 292 includes a quantum well layer. More specifically, each of the non-doped spacer portions 292 includes a spacer 292a, a single layer of an active portion 292b, and a spacer 292c that are disposed in this order. The single layer of the active portion 292b is disposed at a position of an antinode of a standing wave. The active portion 292b includes three layers of quantum wells. The active portion 292b can be constituted by, for example, a multi-quantum well that includes three layers of quantum wells in each of which an InGaAs well layer having a thickness of 8 nm is sandwiched between GaAs barrier layers each having a thickness of 10 nm. A portion other than the spacer 292a and the spacer 292c constituting the non-doped spacer portions 292 is constituted by a non-doped GaAs layer. In this configuration, the band gap difference between each barrier layer and each quantum well layer is 105 meV, and the configuration is an active layer configuration in which carriers are accumulated also in the above-described barrier layers.

To improve tunneling probability, the tunnel junction layer 294 can include a p-type layer and an n-type layer (not illustrated) with high concentration of approximately $10^{19}$ cm$^{-3}$ or more. A high-concentration p-type layer can be disposed on the side near the p-type layer 293 and a high-concentration n-type layer can be disposed on the side near the n-type layer 291.

With such a configuration, the number of carriers generated in the resonator portion 29 is twice the number of carriers in a single junction type, even when electric current injected into the element is the same, and it is thus possible to increase optical power.

Although layers constituting the light emitting element are drawn so as to be in direct contact with each other in Fig. 14, another functional layer may be provided between optionally selected layers.

Although an example of two junctions has been described in the present embodiment, the example is a non-limiting example, and three or more junctions can be used under the same idea. In addition, although an example in which the resonator spacer portion of the multiple junction type is applied to the first embodiment has been described in the present embodiment, the example is a non-limiting example, and the resonator spacer portion of the multiple junction type can be combined, as appropriate, with another embodiment.

In addition, the effect of reducing variation in the array at the emission timing by changing the optical loss in the multiple junction type is exerted also in a configuration in which the p-type layer 293 does not include the oxidized constriction layer 293a.

In each of the first to fourth embodiments, the light emitting element has a configuration in which the saturable absorption layer including the quantum well layer that absorbs light is sandwiched between upper and lower semiconductors of the same conduction type. In other words, the light emitting element does not have a p-n junction or a p-i-n junction that is constituted by different conduction types of layers above and below a layer, such as a quantum well layer, that absorbs light or emits light. Meanwhile, as a VCSEL in which a light absorbing layer is used, a VCSEL having a p-i-n configuration in which both an active layer and a light absorbing layer are sandwiched between a p-type semiconductor layer and an n-type semiconductor layer is also known. In addition to electrode that are each in electrically contact with a corresponding one of the p-type layer and the n-type layer sandwiching the active layer for obtaining a gain of laser oscillation, this VCSEL forms a p-i-n or p-n junction in which a light absorbing layer is sandwiched between a p-type layer and a n-type layer. Then, electrode that are each in electrically contact with a corresponding one of the p-type layer and the n-type layer are further included. In this configuration, any two of the four electrodes can be served by one electrode. Therefore, the number of electrodes is generally three or four. In this configuration, carriers for light emission are injected into the active layer by applying a voltage to the active layer in the forward direction of p-i-n. In addition, a voltage is applied to the light absorbing layer in the forward direction or the reverse direction of p-i-n, and oscillation timing is controlled by conditions of the voltage applied to the light absorbing layer and temporal variation. In this configuration, the characteristics, such as the absorption coefficient of the light absorbing layer and the like, are changed by the voltage and the electric current applied to the light absorbing layer, thereby controlling the oscillation timing.

In such a configuration, it is essential to form a p-i-n junction by sandwiching the light absorbing layer by the p-type layer and the n-type layer to electrically control the light absorbing layer. In a configuration in which the light absorbing layer is sandwiched between layers of the same conduction type (for example, the n-type in the first embodiment) as with the spacer layer including the saturable absorption layer in the above-described embodiment, the electrical control described above is not possible theoretically. Therefore, the design idea is different in terms of whether to make the conduction types of the doped semiconductor layers on both sides of the saturable absorption layer the same or different.

Further, the VCSEL configuration of the above-described embodiment also greatly differs from the VCSEL having the p-i-n configuration in which the light absorbing layer is sandwiched between the p-type semiconductor layer and the n-type semiconductor layer in terms of the design idea of the absorption coefficient of the light absorbing layer. The design concept of a VCSEL having a p-i-n configuration in which both the active layer and the light absorbing layer are sandwiched between p-type and n-type semiconductor layers is as follows. The design idea is an idea of setting the absorption coefficient of the light absorbing layer to be sufficiently high so that laser oscillation does not occur even after electric current injection into the active layer has started and time has elapsed. Conversely, in a state in which laser oscillation is allowed, the absorption coefficient of the light absorbing layer is designed to be sufficiently low through electrical control. Therefore, electrical control is not possible when this structure is used as a base and when the layers above and below the light absorbing layer are of the same conductivity type. Accordingly, the light emitting element becomes a light emitting element in which oscillation occurs before time has elapsed after the start of electric current injection or a light emitting element in which oscillation starts immediately after the start of electric current injection, as in a normal VCSEL, and in which a short pulse having a high peak value is not generated.

In the above-described embodiment, the problems in the comparative example are solved as described above by, as illustrated in Fig. 1, causing electric current to flow from the electrode 42 and the back electrode 140 on the back side of the substrate in the vertical direction in Fig. 1. Then, to cause electric current to flow through the spacer portion 14 in the vertical direction, at least a portion of the spacer portion 14 is doped with an impurity. It is found that doping with an impurity may make optical pulse waveform unpreferable as illustrated in Fig. 5 to Fig. 7 under some conditions compared with the configuration of the comparative example. Specifically, the comparative example has a characteristic in which only one short-duration pulse with a high peak value is generated at the start of laser oscillation, and a small peak is generated in transition to a stable state since laser oscillation continues thereafter. This is a preferable characteristic as a light source for ranging. A reason for the above is that a higher peak value of the optical pulse at the start of oscillation enables distance measurement over longer ranges, and the shorter duration improves ranging accuracy. In addition, since the second and subsequent peaks are low, the probability that errors of ranging values are increased as a result of the second and subsequent peaks being misidentified as the first peak is reduced. However, doping the spacer portion 14 generates a possibility that the peak value of the optical pulse decreases under some conditions and that the intensity of the second and subsequent peaks increases.

The inventors have found a problem of change in the optical pulse form generated by doping in a configuration in which the spacer portion 14 is doped and in which electric current flows in the vertical direction illustrated in Fig. 1. For this problem, it has been found that there are conditions, such as doping concentration and film thicknesses, preferable for the spacer portion 14 to maintain an optical pulse waveform equivalent to that in the comparative example, and both of them are achieved. Conditions to achieve both of them are as described with calculation results in each of the embodiments.

Although the spacer portion 14 in the embodiment described above is disposed at the lower DBR layer 12 and the active layers 24, the spacer portion 14 is not limited to be at this location to generate a short optical pulse. The spacer portion 14 exerts effects when being disposed at a portion that constitutes an optical resonator from a physical principle of generation of optical pulses described above. More specifically, it is sufficient for the spacer portion 14 to be disposed between the lower DBR layer 12 and the upper DBR layer 28. Further, the spacer portion 14 may be disposed between layers constituting the lower DBR layer 12.

Fifth Embodiment

A ranging device according to a fifth embodiment of the present disclosure will be described with Fig. 8. Fig. 8 is a block diagram illustrating a general configuration of the ranging device according to the present embodiment.

A ranging device 200 according to the present embodiment is a ranging device (LiDAR device) in which a surface emission laser array in which the light emitting element of the aforementioned embodiment is two-dimensionally disposed is applied to a light source portion.

The ranging device 200 according to the present embodiment can be constituted by a control unit 210, a surface emission laser array driver 212, a surface emission laser array 214, a light-emission optical system 218, a light-reception optical system 220, an image sensor 222, and a distance data processor 224.

In the surface emission laser array 214, the light emitting element 100 according to the fourth embodiment is mounted in a package. The surface emission laser array driver 212 is a driver portion that receives a driving signal from the control unit 210, generates driving current for causing the surface emission laser array 214 to oscillate, and outputs the driving current to the surface emission laser array 214. The surface emission laser array 214 and the surface emission laser array driver 212 may be served by a single light emitting device.

The light-emission optical system 218 is an optical system that emits a laser beam generated by the surface emission laser array 214 toward a ranging target range. The light-reception optical system 220 is an optical system that guides a laser beam reflected by a measurement object 2000 to the image sensor 222. Note that, although the light-emission optical system 218 and the light-reception optical system 220 are illustrated as a single member in a convex lens shape in Fig. 8, the light-emission optical system 218 and the light-reception optical system 220 are not constituted by only the single member in the convex lens shape and is constituted by a lens group in which a plurality of lenses are combined together.

The image sensor 222 is a photoelectric conversion device in which a plurality of pixels including photoelectric conversion portions are aligned in a two-dimensional array form and is a light receiving device that outputs an electric signal corresponding to incident light. The image sensor 222 can be, for example, a CMOS image sensor or a SPAD sensor. The distance data processor 224 has a function as a distance information acquiring unit that generates and outputs information relating to a distance to the measurement object 2000 present in a ranging target range on the basis of a signal from the image sensor 222. The distance data processor 224 may be disposed inside the same package as the image sensor 222 or may be disposed inside a separate package from the image sensor 222 as long as the distance data processor 224 is electrically connected to the image sensor 222.

The control unit 210 is constituted by an information processing device including a microcomputer and a logic circuit and has a function as a main processing device that manages operations, such as operation control of each portion and various types of arithmetic processing, in the ranging device 200.

As described above, as a light emitting device suitable for a LiDAR system, a light emitting device that is capable of generating an optical pulse with a short optical pulse width and a high peak value is desirable. Specifically, an optical pulse width of a light source suitable for a LiDAR system is, for example, in a range of approximately 50 ps to 1 ns. Meanwhile, light emission with such a short pulse width is not easy from the aspect of the VCSEL and electricity that drives the VCSEL. To obtain an optical pulse having an optical pulse width of approximately 50 ps to 1 ns, the electric current pulse that drives the VCSEL is required to have a similar pulse width since the VCSEL emits light in accordance with the amount of injected electric current. That is, it is necessary in a portion from a driver portion to the VCSEL to treat, as a frequency component, electric current that has excellent electrical characteristics in a high frequency band such as 1 GHz or 10 GHz and that is higher than 1A. Such a situation has a problem that costs are increased compared with when a driver and an electrical transmission portion to a VCSEL are constituted by only an electric circuit that handles only frequency bands lower than the above frequency band.

Thus, the light emitting element described in the aforementioned embodiment is used in the present embodiment to configure such that the VCSEL itself generates a short pulse. Consequently, an optical pulse of approximately 50 ps to 1 ns preferable for the LIDAR system is achieved while cost increase of the driver portion and the electrical transmission portion is avoided.

First, the control unit 210 outputs a driving signal to the surface emission laser array driver 212. The surface emission laser array driver 212 receives the driving signal from the control unit 210 and injects a predetermined electric current value of electric current into the surface emission laser array 214. Consequently, the surface emission laser array 214 oscillates, and a laser beam is output from the surface emission laser array 214. At this time, as described above, the pulse width of the light emitted from the surface emission laser array 214 is narrower than the pulse width of the injected electric current.

The laser beam generated by the surface emission laser array 214 is emitted toward a ranging target range by the light-emission optical system 218. In the laser beam that irradiates the measurement object 2000 present in the ranging target range, a laser beam that is reflected by the measurement object 2000 and enters the light-reception optical system 220 is guided to the image sensor 222 by the light-reception optical system 220.

Each pixel of the image sensor 222 generates an electric signal pulse in accordance with the incident timing of the laser beam. The electric signal pulse generated by the image sensor 222 is input to the distance data processor 224.

On the basis of the reception timing of the electric signal pulse output from the image sensor 222, the distance data processor 224 generates information relating to a distance to the measurement object 2000 in a light propagation direction. Three-dimensional information of the measurement object 2000 can be acquired by calculating distance information based on each of the electric signal pulses output from the pixels of the image sensor 222.

For example in the field of automobiles, the ranging device 200 of the present embodiment is applicable to a control device for performing control to avoid collision with another vehicle or to a control device for performing control of automated driving by following another vehicles. In addition, the ranging device 200 of the present embodiment is applicable not only to automobiles but also to other movable bodies (moving devices) such as a marine vessel, an airplane, or an industrial robot, or to a moving-body detection system or the like. The ranging device 200 of the present embodiment is widely applicable to an instrument that uses information, including distance information, of a three-dimensionally recognized object. These movable bodies can be each configured to include the ranging device of the present embodiment and control means configured to control a movable body on the basis of information relating to a distance acquired by the ranging device.

In addition, the three-dimensional information, including depth, that can be acquired by the ranging device 200 of the present embodiment is also usable in an image photographing device, an image processing device, a display device, and the like. For example, by using the three-dimensional information acquired by the ranging device 200 of the present embodiment, it is possible to display a virtual object on a real-world image without causing a sense of incongruity. In addition, by storing the three-dimensional information together with image information, it is also possible to correct blurs and the like of photographed videos after photographing.

Thus, according to the present embodiment, it is possible to achieve a high-performance ranging device that includes a light emitting device capable of generating an optical pulse having a short optical pulse width and a high peak value.

The present disclosure is not limited to the aforementioned embodiments and can be variously modified. For example, an example in which a configuration of part of any of the embodiments is added to another embodiment and an example in which the configuration is replaced with a configuration of part of another embodiment are also embodiments of the present disclosure. In addition, in the present specification, part of the matters described for the comparative example can be added to or replaced with the aforementioned plurality of embodiments.

In addition, although GaAs, AlGaAs, and InGaAs are presented as examples of semiconductor materials that enable crystal growth when a GaAs substrate is used as the semiconductor substrate 10 in the aforementioned embodiments, the semiconductor substrate 10 is not limited to the GaAs substrate. For example, an InP substrate is also usable as the semiconductor substrate 10. Examples of semiconductor materials that enable crystal growth when the InP substrate is used as the semiconductor substrate 10 are, for example, InP, InGaAs, InGaP, InGaAsP, and the like.

In addition, the DBR layer in the light emitting element according to each of the aforementioned embodiments is not necessarily constituted by a semiconductor material and may be constituted by a material other than a semiconductor material.

All of the aforementioned embodiments merely indicate embodiment examples to carry out the present disclosure, and the technical scope of the present disclosure should not be interpreted by these embodiments in a limited manner. That is, the present disclosure can be embodied in various forms without departing from the technical concept or principal features of the present disclosure.

Various embodiments have been described in detail above but it will be understood that the present disclosure is not limited solely to these embodiments and encompasses all modifications, variants, alternatives and equivalents falling within the scope of the appended claims.

## Claims

1. A light emitting device that is a light emitting element, the light emitting device comprising:

   a first reflecting mirror (12);
   a second reflecting mirror (28);
   a resonator portion (18, 29) including an active layer (24) provided between the first reflecting mirror (12) and the second reflecting mirror (28);
   a first electrode (140) provided below the first reflecting mirror (12);
   a second electrode (42) provided above the resonator portion (18, 29); and
   a spacer portion (14) including a saturable absorption layer (16) provided between the first electrode (140) and the resonator portion (18, 29),
   wherein the spacer portion (14) has a first spacer layer (134) provided on a first side with respect to the saturable absorption layer (16) and a second spacer layer (144) provided on a second side with respect to the saturable absorption layer (16), the second side being opposite to the first side,
   wherein each of the first spacer layer (134) and the second spacer layer (144) is of a first conductivity type, and
   wherein the second reflecting mirror (28) is of a second conductivity type that is a conductivity type opposite to the first conductivity type.

2. The light emitting device according to claim 1,

   wherein the saturable absorption layer (16) comprises a quantum well layer (124) and a barrier layer (114), and
   wherein the barrier layer (114) is comprised of the first conductivity type.

3. The light emitting device according to claim 2,
   wherein the quantum well layer (124) is comprised of the first conductivity type.

4. The light emitting device according to claim 2 or claim 3,
   wherein impurity concentration of each of the barrier layer (114) and the quantum well layer (124) is lower than impurity concentration of each of the first spacer layer (134) and the second spacer layer (144).

5. The light emitting device according to any one of claims 1 to 4,

wherein a semiconductor layer (154, 164) having impurity concentration lower than impurity concentration of each of the first spacer layer (134) and the second spacer layer (144) is included in at least one of a portion between the saturable absorption layer (16) and the first spacer layer (134) and a portion between the saturable absorption layer (16) and the second spacer layer (144).

6. The light emitting device according to any one of claims 2 to 5,
wherein impurity concentration of each of the barrier layer (114) and the quantum well layer (124) is less than or equal to $5.6 \times 10^{18}$ cm$^{-3}$.

7. The light emitting device according to any one of claims 2 to 5,
wherein impurity concentration of each of the barrier layer (114) and the quantum well layer (124) is less than or equal to $2.1 \times 10^{18}$ cm$^{-3}$.

8. The light emitting device according to claim 1,

wherein the saturable absorption layer (16) comprises a quantum well layer (124) and a barrier layer (114), and
wherein each of the quantum well layer (124) and the barrier layer (114) comprises a non-doped semiconductor layer.

9. The light emitting device according to claim 8,
wherein the non-doped semiconductor layer is provided in at least one of a portion between the saturable absorption layer (16) and the first spacer layer (134) and a portion between the saturable absorption layer (16) and the second spacer layer (144).

10. The light emitting device according to claim 8 or claim 9,
wherein a thickness of the barrier layer (114) is 2.5 nm or more and 47.5 nm or less.

11. The light emitting device according to claim 8 or claim 9,
wherein a thickness of the barrier layer (114) is 2.5 nm or more and 30 nm or less.

12. The light emitting device according to claim 1,

wherein the saturable absorption layer (16) comprises a quantum well layer (124) and a barrier layer (114), and
wherein the barrier layer (114) is comprised of the second conductivity type.

13. The light emitting device according to claim 12,
wherein the quantum well layer (124) is comprised of the second conductivity type.

14. The light emitting device according to any one of claims 1 to 13,
wherein a depletion layer (310) is formed at an entirety of the saturable absorption layer (16).

15. The light emitting device according to any one of claims 1 to 14,
wherein the spacer portion (14) is included in the first reflecting mirror (12).

16. The light emitting device according to any one of claims 1 to 15,
wherein the light emitting element emits light that has a maximum peak value and that has a profile of being settled at a stable value that is predetermined optical intensity after the maximum peak value.

17. The light emitting device according to any one of claims 1 to 16,

wherein, when a light confinement coefficient of the active layer (24) is represented by Γs, a light confinement coefficient of the saturable absorption layer (16) is represented by Γa, a maximum gain obtained in the active layer (24) when a value of injected electric current is Iop is represented by gmax(Iop), an absorption coefficient of the saturable absorption layer (16) is represented by $\alpha 2$, a mirror loss is represented by $\alpha m$, and light absorption by a carrier is represented by $\alpha i$,
a relationship expressed by Γs $\times$ gmax(Iop) > Γa $\times$ $\alpha 2$ + $\alpha m$ + $\alpha i$ is satisfied.

18. The light emitting device according to any one of claims 2 to 13,

wherein the quantum well layer (124) is constituted by InGaAs, and
wherein the barrier layer (114) is constituted by GaAs.

19. The light emitting device according to any one of claims 2 to 18,

wherein the active layer (24) has a quantum well layer (124) and a barrier layer (114), and
wherein at least one of a band gap difference between the quantum well layer (124) and the barrier layer (114) of the active layer (24) and a band gap difference between the quantum well layer (124) and the barrier layer (114) of the saturable absorption layer (16) is 60 meV or more and 230 meV or less.

20. The light emitting device according to any one of claims 2 to 18,

wherein the active layer (24) has a quantum well layer (124) and a barrier layer (114), and
wherein a band gap difference between a quantum well layer (124) and a barrier layer (114) of at least one of the active layer (24) and the saturable absorption layer (16) is 105 meV or more and 230 meV or less.

21. The light emitting device according to any one of claims 1 to 20,
wherein an optical thickness of a layer located between the first reflecting mirror (12) and the second reflecting mirror (28) is more than or equal to a thickness corresponding to five times a resonant wavelength.

22. The light emitting device according to any one of claims 1 to 21,
wherein an optical thickness of a layer located between the first reflecting mirror (12) and the second reflecting mirror (28) is more than or equal to a thickness corresponding to eleven times a resonant wavelength.

23. A ranging device (200) comprising:

the light emitting device according to any one of claims 1 to 22;
a light receiving device that receives light emitted from the light emitting device and reflected by a measurement object (2000); and
a distance information acquiring unit that acquires information relating to a distance to the measurement object (2000) based on a time difference between a timing at which light is emitted from the light emitting device and a timing at which the light receiving device receives the light.

24. A movable body comprising:

the ranging device (200) according to claim 23; and
control means configured to control the movable body based on information that relates to the distance and that is acquired by the ranging device (200).

# FIG. 1A

# FIG. 1B

FIG. 2

# FIG. 3A

# FIG. 3B

# FIG. 4

# FIG. 5

# FIG. 6A

# FIG. 6B

# FIG. 7

# FIG. 8

# FIG. 9A

# FIG. 9B

FIG. 10

# FIG. 11A

# FIG. 11B

## FIG. 12A

## FIG. 12B

## FIG. 12C

# FIG. 13A

# FIG. 13B

# FIG. 14

# FIG. 15

Europäisches
Patentamt
European
Patent Office
Office européen
des brevets

# EUROPEAN SEARCH REPORT

**Application Number**

EP 25 20 2839

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/291799 A1 (KONTTINEN JANNE [FI]) 20 December 2007 (2007-12-20) * paragraphs [0034] - [0040]; figure 1 * | 1-24 | INV. H01S5/042 G01S7/484 H01S5/06 H01S5/183 |
| X | EP 0 830 718 B1 (HONEYWELL INC [US]) 27 September 2000 (2000-09-27) * paragraphs [0026] - [0033]; figure 1 * | 1-11, 14-24 | ADD. H01S5/065 |
| X | EP 3 419 123 A1 (KONINKLIJKE PHILIPS NV [NL]) 26 December 2018 (2018-12-26) * paragraphs [0036] - [0040]; figure 4 * | 1-11, 14-24 | |
| A | EP 4 343 990 A1 (CANON KK [JP]) 27 March 2024 (2024-03-27) * the whole document * * paragraphs [0025], [0038], [0040] * | 16-24 | |

TECHNICAL FIELDS SEARCHED (IPC)

H01S
G01S

The present search report has been drawn up for all claims

| Place of search | Date of completion of the search | Examiner |
|---|---|---|
| Munich | 4 February 2026 | Riechel, Stefan |

EPO FORM 1503 03.82 (P04C01)

## ANNEX TO THE EUROPEAN SEARCH REPORT
## ON EUROPEAN PATENT APPLICATION NO.

EP 25 20 2839

This annex lists the patent family members relating to the patent documents cited in the above-mentioned European search report.
The members are as contained in the European Patent Office EDP file on
The European Patent Office is in no way liable for these particulars which are merely given for the purpose of information.

04-02-2026

| Patent document cited in search report | Publication date | Patent family member(s) | | Publication date |
|---|---|---|---|---|
| US 2007291799 A1 | 20-12-2007 | EP | 2041849 A1 | 01-04-2009 |
| | | US | 2007291799 A1 | 20-12-2007 |
| | | WO | 2007144471 A1 | 21-12-2007 |
| EP 0830718 B1 | 27-09-2000 | CA | 2221308 A1 | 19-12-1996 |
| | | DE | 69610499 T2 | 01-02-2001 |
| | | EP | 0830718 A1 | 25-03-1998 |
| | | JP | H11511292 A | 28-09-1999 |
| | | US | 5574738 A | 12-11-1996 |
| | | WO | 9641403 A1 | 19-12-1996 |
| EP 3419123 A1 | 26-12-2018 | CN | 110892596 A | 17-03-2020 |
| | | EP | 3419123 A1 | 26-12-2018 |
| | | EP | 3642915 A1 | 29-04-2020 |
| | | JP | 2020524910 A | 20-08-2020 |
| | | KR | 20200024845 A | 09-03-2020 |
| | | US | 2020161833 A1 | 21-05-2020 |
| | | WO | 2018234131 A1 | 27-12-2018 |
| EP 4343990 A1 | 27-03-2024 | CN | 117321868 A | 29-12-2023 |
| | | EP | 4343990 A1 | 27-03-2024 |
| | | JP | 7646596 B2 | 17-03-2025 |
| | | JP | 2022176886 A | 30-11-2022 |
| | | JP | 2025078724 A | 20-05-2025 |
| | | KR | 20230164160 A | 01-12-2023 |
| | | US | 2024085534 A1 | 14-03-2024 |
| | | WO | 2022244674 A1 | 24-11-2022 |

EPO FORM P0459

For more details about this annex : see Official Journal of the European Patent Office, No. 12/82

**REFERENCES CITED IN THE DESCRIPTION**

**Patent documents cited in the description**

• JP 2022176886 A